Europäisches Patentamt

European Patent Office

Office européen des brevets

(19)

(11) Numéro de publication : **0 496 664 A2**

(12)

# DEMANDE DE BREVET EUROPEEN

(21) Numéro de dépôt : **92400151.4**

(51) Int. Cl.$^5$ : **H01L 39/14, H01L 39/24**

(22) Date de dépôt : **21.01.92**

(30) Priorité : **24.01.91 FR 9100796**

(43) Date de publication de la demande :
**29.07.92 Bulletin 92/31**

(84) Etats contractants désignés :
**CH DE GB IT LI**

(71) Demandeur : **ALSTHOM INTERMAGNETICS SA**
**3 avenue des Trois Chênes**
**F-90018 Belfort Cédex (FR)**

(72) Inventeur : **Peltier, François**
**44, rue du Verboté**
**F-90350 Evette-Salbert (FR)**
Inventeur : **Hoang, Gia Ky**
**9 Domaine de l'Etang**
**F-90300 Cravanche (FR)**
Inventeur : **Sulten, Philippe**
**26B, rue d'Evette**
**F-90350 Evette-Salbert (FR)**
Inventeur : **Grunblatt, Gérard**
**Route Champagney**
**F-70400 Errevet (FR)**

(74) Mandataire : **Vigand, Privat et al**
**SOSPI 14-16, rue de la Baume**
**F-75008 Paris (FR)**

(54) **Procédé d'assemblage de billettes composites pour la fabrication de brins supraconducteurs multifilamentaires et billettes composites ainsi assemblées.**

(57) L'invention concerne un procédé d'assemblage de billettes composites (2) à section circulaire pour la fabrication de brins supraconducteurs multifilamentaires dans lequel on remplit un corps cylindrique (1) avec des tiges de section carrée élémentaires (3) à base d'alliages métalliques ou en métal.
Les billettes sont constituées de tiges élémentaires (3) de section carrée à l'intérieur d'un corps (1).
Facilité d'assemblage des billettes et compacité des billettes obtenues.

EP 0 496 664 A2

FIG. 1

FIG. 2

La présente invention a pour objet un procédé d'assemblage de billettes composites pour la fabrication de brins supraconducteurs multifilamentaires et notamment de fils supraconducteurs à base d'alliages métalliques (NbTi, Nb$_3$ Sn...) ainsi que de tout autre composite à renforcement fibreux.

Le procédé conventionnel de fabrication de fils supraconducteurs comporte une ou plusieurs extrusions à chaud des billettes composites suivies d'étirage et de tréfilage jusqu'au diamètre final. Ces billettes sont généralement constituées d'un corps cylindrique qui contient selon les cas, quelques centaines à quelques dizaines de milliers de composants présentées sous forme de tiges qui pourront être elles-mêmes composites.

La réduction du nombre d'extrusions est une des voies possibles à suivre, afin de réduire les coûts de fabrication, et en même temps d'améliorer les performances du brin supraconducteur. Une telle réduction serait possible si l'on pouvait fabriquer des billettes comportant un nombre important de tiges. Mais la confection de telles billettes présente des difficultés d'ordre pratique qui croissent avec le nombre de composants :

- Avec les tiges de section hexagonale, habituellement utilisées pour assurer un bon remplissage, le temps nécessaire pour l'empilement est long. De plus étant donné que les tiges ne sont pas parfaitement droites et présentent toujours un léger vrillage, l'assemblage est très difficile et croît avec le nombre de tige. Le nombre de tiges hexagonales assemblables de façon correcte reste très limité.

- L'utilisation des tiges de section circulaire permet une réduction du temps d'empilement mais conduit à un mauvais taux de remplissage, qui est dû à l'existence des espaces vides entre ces dernières.

Le procédé selon l'invention est caractérisé en ce qu'on empile dans le corps cylindrique des tiges élémentaires de section carrée.

Chaque tige élémentaire à section carrée est entourée de quatre tiges au lieu de six comme c'est le cas lorsqu'on utilise des tiges à section hexagonale ; étant donné que l'empilement d'une tige dépend de conditions aux interfaces et que l'obtention d'une tige parfaitement droite et non vrillée, quelle que soit la section, est une chose technologiquement impossible, il est plus facile d'empiler une tige à section carrée que d'empiler une tige à section hexagonale.

Pour diminuer le temps d'assemblage et faciliter l'empilement on procède par étapes. C'est-à-dire qu'on empile d'abord des tiges élémentaires de section carrée pour former des barreaux de section carrée ou rectangulaire puis ensuite on empile ces barreaux dans le corps.

De préférence ces barreaux sont de grosseurs différentes ce qui diminue encore le temps d'assemblage.

L'invention concerne également des billettes composites à section circulaire pour la fabrication de brins supraconducteurs multifilamentaires constituées par un corps cylindrique rempli de tiges polygonales élémentaires à base d'alliages ou en métal et empilées, caractérisée en ce que les tiges élémentaires ont une section carrée.

Entre les tiges élémentaires à section carrée il y a moins de surface de contact ce qui diminue le risque d'avoir des espaces vides entre les tiges.

La billette selon l'invention est donc plus compacte que celles constituées de tiges de section polygonale et beaucoup moins évidemment que celles constituées de tiges de section circulaire.

Les brins fabriqués avec cette billette auront donc de meilleures caractéristiques.

L'invention va maintenant être décrite plus en détail en se référant à un mode de réalisation particulier à titre d'exemple non limitatif illustré par des dessins annexés.

La figure 1 représente une billette selon l'invention.

La figure 2 représente les barreaux de tiges utilisés pour l'assemblage de la billette de la figure 1.

Selon le procédé de l'invention on remplit le corps 1 de la billette 2 qui est un cylindre en cuivre ou en cupro-nickel disposé horizontalement avec des tiges élémentaires 3 de section carrée en commençant par le bas du corps.

Dans l'exemple décrit la billette comprend 3876 tiges composites sur le pourtour entourant 1092 tiges de cuivre formant le centre 7 de la billette 2. Les tiges ont une section de 2,2 x 2,2 mm$^2$.

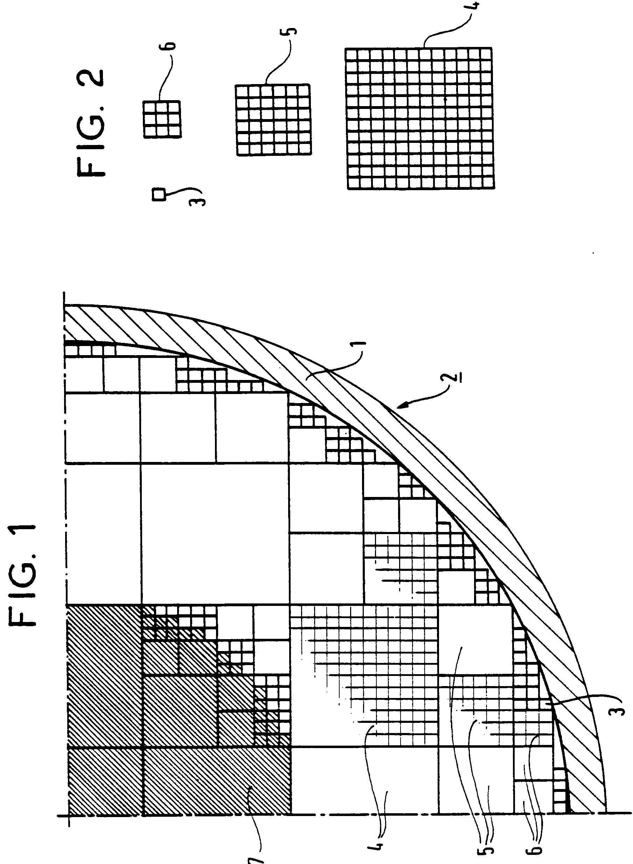

Selon une variante du procédé au lieu d'empiler les tiges 3 une à une dans le corps 1 on fabrique d'abord des barreaux 4, 5, 6 de sections carrées de diverses grosseurs par empilement de tiges élémentaires 3 (voir figure 2).

Le barreau 4 a été réalisé par l'empilement de 12 x 12 (144) tiges élémentaires 3. Le barreau 5 a été réalisé par l'empilement de 6 x 6 (36) tiges élémentaires 3 et de barreau 6 a été réalisé par l'empilement de 3 x 3 (9) tiges 3.

Ces barreaux sont simples à obtenir et on empile ensuite ces barreaux (4, 5, 6) après avoir disposé des tiges élémentaires 3 le long du corps 1 pour occuper l'espace resté vide.

Le corps 1 de la billette 2 est ainsi remplit par l'empilement des tiges de section carrée 3 plus rapidement qu'en les empilant une à une.

**Revendications**

1/ Procédé d'assemblage de billettes composites (2) à section circulaire pour la fabrication de brins supraconducteurs multifilamentaires dans lequel on remplit un corps cylindrique (1) avec des tiges polygonales élémentaires à base d'alliages métalliques ou en métal, caractérisé en ce qu'on empile dans le corps cylindrique (1) des tiges élémentaires de section carrée (3).

2/ Procédé selon la revendication 1, caractérisé en ce qu'on empile dans le corps cylindrique (1) des barreaux (3, 4, 5) de section carrée et/ou rectangulaire constitués de tiges élémentaires (3) de section carrée empilées.

3/ Procédé selon la revendication 2, caractérisé en ce que les barreaux (3, 4, 5) ont des grosseurs différentes.

4/ Billettes composites à section circulaire pour la fabrication de brins supraconducteurs multifilamentaires constitué par un corps cylindrique (1) rempli de tiges polygonales élémentaires (3) empilées à base d'alliages ou en métal, caractérisées en ce que les tiges élémentaires (3) ont une section carrée.

FIG. 1

FIG. 2